# EUROPEAN PATENT SPECIFICATION

(11) **EP 3 783 833 B1**
(45) Date of publication and mention of the grant of the patent: **16.08.2023**
(21) Application number: 19883706.4
(22) Date of filing: 06.11.2019
(51) Int. Cl.: H04L 12/10, H04L 12/40, G01R 19/165

(54) **COMMUNICATION DEVICE AND EFFECTIVENESS DETECTION METHOD**
KOMMUNIKATIONSVORRICHTUNG UND VERFAHREN ZUR WIRKSAMKEITSDETEKTION
DISPOSITIF DE COMMUNICATION ET PROCÉDÉ DE DÉTECTION D'EFFICACITÉ

(30) Priority: 12.11.2018 CN 201811341152
(43) Date of publication of application: 24.02.2021
(73) Proprietor: HUAWEI TECHNOLOGIES CO., LTD., Shenzhen, Guangdong 518129 (CN)
(72) Inventor: WANG, Haifei, Shenzhen, Guangdong 518129 (CN)
(74) Representative: Gill Jennings & Every LLP
(86) International application number: PCT/CN2019/116084
(87) International publication number: WO 2020/098550

(56) References cited:
- WO-A1-2018/109567
- CN-A- 101 124 775
- CN-A- 101 860 443
- CN-A- 102 142 769
- CN-A- 104 422 839
- CN-A- 106 161 041
- JP-A- 2017 069 972
- US-B2- 8 839 008

## Description

### TECHNICAL FIELD

This application relates to the field of communications technologies, and in particular, to a powered device for use in a power over Ethernet system and a method for operating the same.

### BACKGROUND

A power over Ethernet (power over Ethernet, PoE) technology is a technology in which power and data are simultaneously transmitted to a device through a twisted pair on the Ethernet. Power may be transmitted by multiplexing an existing Ethernet cable, thereby saving space and costs and facilitating management. The power over Ethernet technology is widely used in fields such as an (Internet protocol, IP) phone, wireless network construction, safety protection, and building management.

A PoE power supply system mainly includes power sourcing equipment (power sourcing equipment, PSE) and a powered device (powered device, PD). The PSE is a device that supplies power to an Ethernet client device, and is also a manager of an entire power over Ethernet process. The PD is a PSE load that receives power supply. In the PoE power supply system, before supplying power to the PD, the PSE needs to detect validity of the PD, that is, determine whether the PD connected to the PSE can be powered by the PSE. When determining that the PD is valid (that is, the PD can be powered by the PSE), the PSE supplies power to the PD (the PD is powered on).

In the prior art, the PSE performs validity detection on the PD by using an impedance identification method. The PSE applies a current to a powered load in the PD, and detects whether a voltage on the powered load is within a specified range; and if the voltage on the powered load is within the specified range, determines that the PD is valid, or otherwise, determines that the PD is invalid. However, powered loads of different PDs have different resistance values. Consequently, accuracy of a PD validity detection result obtained by using the foregoing method is relatively low. As a result, power supply safety of the PD is affected.

WO2018109567 relates to powered communication device. JP2017069972 relates to power over data line detection and classification scheme using PD information stored in memory.

### SUMMARY

This application provides a powered device and a method that improve accuracy of detection of the powered device.

The invention has been defined in the independent claims. Further specific technical features have been defined in the dependent claims.

### BRIEF DESCRIPTION OF DRAWINGS

FIG. 1 is a schematic structural diagram of a power over Ethernet system according to an implementation of this application;
FIG. 2 is a schematic diagram of a power over Ethernet process according to an implementation of this application;
FIG. 3 is a schematic structural diagram of a first communications device according to an implementation of this application;
FIG. 4 is a first schematic diagram of a specific structure of a first communications device according to an implementation of this application;
FIG. 5 is a second schematic diagram of a specific structure of a first communications device according to an implementation of this application;
FIG. 6 is a third schematic structural diagram of a first communications device according to an implementation of this application; and
FIG. 7 is a schematic structural diagram of a communications system according to an implementation of this application.

### DESCRIPTION OF IMPLEMENTATIONS

To make the objectives, technical solutions, and advantages of this invention clearer, the following further describes various implementations in detail with reference to the accompanying drawings. The implementations described below are not all claimed, they are included to help understanding the context of the invention. While the description refers to various implementations, the embodiments of the invention are those which comprise at least all the features of an independent claim. Any implementation which does not fall within the scope of the claims does not form part of the invention, but rather included as an illustrative example that is useful for understanding the invention.

To improve accuracy of validity detection of a device, this application provides a first communications device and a validity detection method. The method and the device are based on a same inventive concept. Because problem-resolving principles of the method and the device are similar, implementation of the device and the method may be mutually referred to. No repeated description is provided.

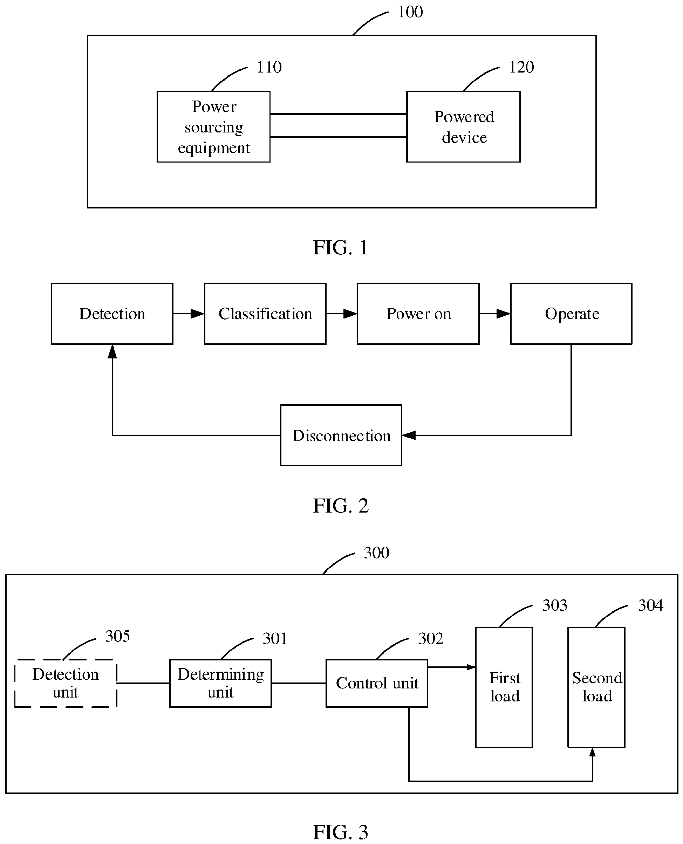

The first communications device and the validity detection method provided in this application may be applied to a power over Ethernet system. As shown in FIG. 1, a power over Ethernet system 100 includes power sourcing equipment 110 and a powered device 120. The power sourcing equipment 110 is connected to the powered device 120 by using an Ethernet cable. The first communications device may be the powered device 120. The power sourcing equipment 110 superimposes power on the Ethernet cable to supply power to the powered device 120 for use. In addition, the power sourcing equipment 110 is further responsible for monitoring and managing an operation state of the connected powered device 120. One piece of power sourcing equipment 110 may be connected to one or more powered devices 120. The powered device 120 is a device that receives power over Ethernet. The powered device 120 obtains power and data transmitted by the power sourcing equipment 110 by using the Ethernet cable, and sends data to the power sourcing equipment 110 by using the Ethernet cable.

Specifically, the power sourcing equipment 110 may be an exchange, a hub, a router, or the like. The powered device 120 may be a wireless access point (access point, AP), a camera, an IP phone, a smart speaker, a smart light, a robot arm, a smart charger, or the like.

The power over Ethernet process includes five operation states: detection (detection), classification (classification), power on (power-up), operation (operation), and disconnection (disconnection). Herein, as shown in FIG. 2, classification is an optional process. Detection is a process in which the power sourcing equipment 110 identifies the connected powered device 120. Validity of the powered device 120 is detected to determine whether to supply power to the powered device 120. When the power sourcing equipment 110 determines that the powered device 120 is valid, the power sourcing equipment 110 may continue to detect a power level of the powered device 120, and supply power to the powered device 120 based on the power level of the powered device 120. The powered device 120 enters a power-on process and can normally operate. Alternatively, when the power sourcing equipment 110 determines that the powered device 110 is valid, the power sourcing equipment 110 may directly supply power to the powered device 120 based on a default power. The powered device 120 enters a power-on phase and can normally operate. When the powered device 120 is disconnected from a network, the power sourcing equipment 110 quickly stops power supply to the powered device 120, and repeats a detection process.

In addition, it should be understood that, in the description of this application, "a plurality of" means two or more, and terms such as "first" and "second" are only used for a purpose of distinguishing between descriptions, but cannot be understood as indication or implication of relative importance, and cannot be understood as an indication or implication of a sequence.

As shown in FIG. 3, this application provides a first communications device 300. The first communications device 300 includes a determining unit 301, a control unit 302, a first load 303, and a second load 304. The determining unit 301 is configured to determine that a current state is a first state. The control unit 302 is configured to control the first load 303 to be in a connected state. The second load 304 is in a disconnected state in all or a part of a time in which the first load is in the connected state. The control unit 302 is further configured to control the second load 304 to be in the connected state.

That the first load 303 is in the connected state indicates that the first load 303 is in a path connection state, there is a current flowing through the first load 303, and the first load 303 is in an operation state. That the second load 304 is in the disconnected state indicates that the second load 304 is in an open circuit state, and there is no current flowing through the second load 304. That the second load 304 is in the connected state indicates that the second load 304 is in a path connection state, there is a current flowing through the second load 304, and the second load 304 is in an operation state.

Specifically, the control unit 302 may control a controllable switch connected to the first load 303 to control the first load 303 to be in the connected state or the disconnected state. Likewise, the control unit 302 may control a controllable switch connected to the second load 304 to control the second load 304 to be in the connected state or the disconnected state.

It should be noted that the control unit configured to control the first load 303 to be in the connected state and the control unit configured to control the second load 304 to be in the connected state may be a same control unit, or may be two different control units: a first control unit and a second control unit respectively. The control unit 303, the first control unit, and the second control unit may be chips, for example, a micro control unit (microcontroller unit, MCU), a central processing unit (central processing unit, CPU), and the like. The control unit 303, the first control unit, and the second control unit may alternatively be control circuits.

Specifically, the first load 303 may be a discrete component or an apparatus including a plurality of components such as a resistor, which can identify validity of the first communications device 300 by using an impedance of itself, for example, a signature resistor, a feature resistor, or a testing resistor. The second load 304 is a powered load in the first communications device 300.

Further, the first state may be a detection state. The detection state may be specifically a DO_DETECTION state, to indicate that the second communications device connected to the first communications device 300 performs validity detection on the first communications device 300.

Further, in all or a part of a time of the first state, the second load 304 is in the disconnected state. In other words, when the determining unit 301 determines that the current state is the first state, the second load 304 is in the disconnected state; or when the determining unit 301 determines that the current state is the first state, the second load 304 is in the disconnected state.

In possible implementation, the control unit 302 is further configured to: when the second load 304 is in the connected state, control the first load 303 to be in the disconnected state, so that the first load 303 does not affect the second load 304 when the second load 304 is in an operation state. Especially in a scenario in which the first communications device 300 is connected to the second communications device by using only a pair of cables, when the second load 304 is in the connected state, the first communications device 300 controls the first load 303 to be in the disconnected state, so that the first load 303 is not connected in parallel between the pair of cables when the second communications device completes the validity detection on the first communications device 300. In this way, the following case can be avoided: The first load 303 affects data transmission between the first communications device 300 and the second communications device when the first communications device operates.

In a specific implementation, the determining unit 301 is specifically configured to: receive instruction information sent by the second communications device, and determine, based on the instruction information, that the current state is the first state, where the instruction information is used to instruct the first communications device 300 to determine that the current state is the first state. Specifically, the instruction information may be a voltage signal or a current signal used to trigger the first communications device 300 to enter the first state, for example, a square wave signal and/or a pulse signal; or may be a message used to instruct the first communications device 300 to determine that the current state is the first state.

Further, the first communications device 300 may further include a detection unit 305. The detection unit 305 is configured to detect whether a first condition is met. When the determining unit 301 determines that the current state is the first state, the determining unit 301 is specifically configured to determine, based on a detection result of the detection unit 305, that the current state is the first state.

Specifically, the detection unit 305 is specifically configured to detect whether a voltage output by the second communications device to the first communications device 300 meets the first condition. The first condition is that the voltage output by the second communications device to the first communications device is greater than or equal to a specified voltage threshold, or the first condition is that the voltage output by the second communications device to the first communications device is within a specified voltage range.

Alternatively, the detection unit 305 is specifically configured to detect whether a current output by the second communications device to the first communications device 300 meets the first condition. The first condition is that the current output by the second communications device to the first communications device is greater than or equal to a specified current threshold, or the first condition is that the current output by the second communications device to the first communications device is within a specified current range.

The detection unit 305 may be a determining apparatus, for example, may be a chip; or a power controller configured to detect a voltage or a current. When the detected voltage or current meets the first condition, the determining unit 301 determines that the current state is the first state.

In a possible implementation, the determining unit 301 is further configured to determine that the current state is a second state. The second state may be a classification state, for example, a DO_CLASS_EVENT state; or may be a power-on state, for example, a POWERED state.

Further, the detection unit 305 is configured to: in all or the part of the time in which the first load 303 is in the connected state, detect whether a second condition is met. When the determining unit 301 determines that the current state is the second state, the determining unit 301 is specifically configured to determine, based on a detection result of the detection unit, that the current state is the second state.

Specifically, the detection unit 305 is specifically configured to detect whether a voltage output by the second communications device to the first communications device 300 meets the second condition. The second condition is that the voltage output by the second communications device to the first communications device 300 is greater than or equal to a specified voltage threshold, and duration of the voltage output by the second communications device to the first communications device 300 is greater than a specified value; or the second condition is that the voltage output by the second communications device to the first communications device 300 is less than the specified voltage threshold; or the second condition is that the voltage output by the second communications device to the first communications device 300 is outside a specified voltage range.

Alternatively, the detection unit 305 is specifically configured to detect whether a current output by the second communications device to the first communications device 300 meets the second condition. The second condition is that the current output by the second communications device to the first communications device 300 is greater than or equal to a specified current threshold, and duration of the current output by the second communications device to the first communications device 300 is greater than a specified value; or the second condition is that the current output by the second communications device to the first communications device 300 is less than the specified current threshold; or the second condition is that the current output by the second communications device to the first communications device 300 is outside a specified current range.

It should be noted that the detection unit 305 and the determining unit 301 may be two independent modules, or may be integrated and implemented by using one module. In addition, a validity detection manner for the first communications device 300 is mainly improved in this implementation of this application. However, it should be understood that the first communications device 300 provided in this implementation of this application is a complete device having a structure of an existing communications device, for example, a data transceiver. Only components in the first communications device 300 that are related to the validity detection are described herein. Other components are not described herein.

In the foregoing solution, the first communications device 300 may further use the determining unit 301 to determine that the current state is the first state, and use the control unit 302 to control the first load 303 to be in the connected state. The second load 304 is in the disconnected state in all or the part of the time in which the first load 303 is in the connected state. In other words, when the first communications device 300 is in the first state, the first load 303 operates, and the second load 304 does not operate, so that the second communications device connected to the first communications device 300 performs validity detection on the first communications device 300 by using the first load 303, which is not affected by the second load. In addition, standard configuration may be performed on an impedance of the first load 303 according to a requirement. In comparison with the prior art, a detection result has relatively high accuracy. In addition, the first communications device 300 may further use the control unit 302 to control the second load 304 to be in the connected state, so that the first communications device can be normally powered on and operate after the validity detection is completed.

The following uses an example in which the first communications device 300 is the powered device 120 in the power over Ethernet system 100, and the second communications device is the power sourcing equipment 110, to describe a specific structure of the first communications device 300 in detail.

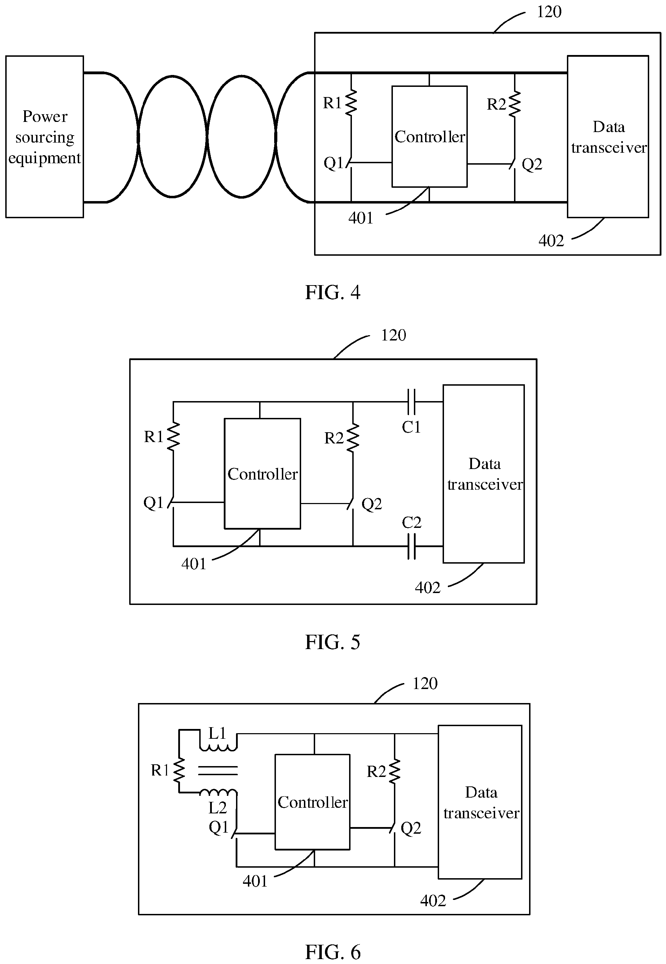

As shown in FIG. 4, the powered device 120 includes a controller 401, a data transceiver 402, a powered load R1, a signature resistor R2, a first controllable switch Q1, and a second controllable switch Q2. The controller 401 is configured to implement functions of the determining unit 301, the control unit 302, and the detection unit 305. The powered load R1 is configured to implement a function of the second load 304. The signature resistor R2 is configured to implement a function of the first load 303.

A first end of the powered resistor R1 is separately connected to a first port of the data transceiver 402 and a first port of the controller 401. A second end of the powered load R1 is connected to a first end of the first controllable switch Q1. A second end of the first controllable switch Q1 is separately connected to a second port of the data transceiver 402 and a second port of the controller 401. A first end of the signature resistor R2 is separately connected to a first port of the data transceiver 402 and a first port of the controller 401. A second end of the signature resistor R2 is connected to a first end of the second controllable switch Q2. A second end of the second controllable switch Q2 is separately connected to a second port of the data transceiver 402 and a second port of the controller 401. The controller 401 is further connected to a third end of the first controllable switch Q1 and a third end of the second controllable switch Q2. The first port of the controller 401 and the first port of the data transceiver 402 are further configured to connect to the power sourcing equipment 110 by using a first cable. The second port of the controller 401 and the second port of the data transceiver 402 are further configured to connect to the power sourcing equipment 110 by using a second cable.

The following describes the foregoing components included in the power sourcing equipment 120 in detail with reference to FIG. 4.

The controller 401 is configured to: when it is determined that a current state of the powered device 120 is a first state, that is, when it is determined that the power sourcing equipment 110 performs validity detection on the powered device 120, control disconnection of the first controllable switch Q1 and connection of the second controllable switch Q2, so that the signature resistor R1 is in a connected state and the powered load R2 is in a disconnected state; or when it is determined that a current state of the powered device 120 is a second state, that is, when it is determined that the power sourcing equipment 110 completes validity detection on the powered device 120, control connection of the first controllable switch Q1 and disconnection of the second controllable switch Q2, so that the signature resistor R1 is in a disconnected state and the powered load R2 is in a connected state.

The data transceiver 402 is configured to: obtain, by using the first cable and the second cable, power transmitted by the power sourcing equipment 110, and perform data transmission to the power sourcing equipment 110 by using the first cable and the second cable.

The controller 401 may be a component or a chip that can control a powered process of the powered device 120, for example, a PD chip. The data transceiver 402 is a component or a chip that can perform data receiving/transmission and that is irrelevant to a transmission medium of a data signal, for example, a port physical layer (port physical layer, PHY) transceiver. A resistance value of the signature resistor R2 is greater than resistance values of the first cable and the second cable, to minimize effects from the first cable and the second cable to the validity detection on the powered device 120.

The first controllable switch Q1 may be a switch such as a bipolar junction transistor (bipolar junction transistor, BJT), a metal-oxide semiconductor field-effect transistor (metal-oxide semiconductor field-effect transistor, MOSFET), an insulated gate bipolar transistor (insulated gate bipolar transistor, IGBT), or a relay. The second controllable switch Q2 may be a switch such as a BJT, a MOSFET, an IGBT, or a relay. The first controllable switch Q1 and the second controllable switch Q2 may be switches in a same type, or may be switches in different types. It should be noted that the foregoing specific types of the first controllable switch Q1 and the second controllable switch Q2 are merely for example and do not constitute any limitation on this application. Switches that can implement disconnection or connection under control of the controller 401 are all applicable to this application.

Further, because the first cable and the second cable are both used to transmit power and data, the first port and the second port of the data transceiver 402 further have data splitting functions. Alternatively, the first port and the second port of the data transceiver 402 are respectively connected to data splitting components, so that the data transceiver 402 can receive data transmitted on the first cable and the second cable. In addition, it can be further ensured that a direct current transmitted in the first cable and the second cable does not enter the PHY layer and only supplies power to a power supply circuit. Specifically, as shown in FIG. 5, the data splitting components connected to the first port and the second port of the data transceiver 402 are respectively a first capacitor C1 and a second capacitor C2.

In a possible implementation, as shown in FIG. 6, the powered device 120 further includes a first inductor L1 and a second inductor L2. The first inductor L1 and the second inductor L2 are coupled to each other. A first end of the first inductor L1 is separately connected to the first port of the data transceiver 402 and the first port of the controller 401. A second end of the first inductor L 1 is connected to the first end of the powered load R1. The second end of the powered load R1 is connected to a first end of the second inductor L2. A second end of the second inductor L2 is connected to the first end of the first controllable switch Q1. The first inductor L1 and the second inductor L2 are electromagnetic interference (electromagnetic interference, EMI) filter inductors configured to avoid a ripple and a noise of a power supply signal and effects from distortion of data signals on data transmission due to high-order harmonic wave interference to the data signals transmitted in the first cable and the second cable.

It should be noted that specific existence forms of the controller 401, the powered load R1, the signature resistor R2, the first controllable switch Q1, and the second controllable switch Q2 in the powered device 120 are not limited in this implementation of this application. The controller 401, the powered load R1, the signature resistor R2, the first controllable switch Q1, and the second controllable switch Q2 all may be discrete components. Alternatively, one or more of the powered load R1, the signature resistor R2, the first controllable switch Q1, and the second controllable switch Q2 may be integrated with the controller 401. The powered device 120 may be connected to the power sourcing equipment 110 by using one or more (two or more, for example, four) pairs of cables. When the powered device 120 is connected to the power sourcing equipment 110 by using a plurality of pairs of cables, the first cable and the second cable are a pair of cables that can be used to supply power to the powered device in the plurality of pairs of cables.

In addition, the first cable may be connected to a positive electrode of a power supply in the power sourcing equipment, and the second cable may be connected to a negative electrode of the power supply in the power sourcing equipment; or the first cable may be connected to a negative electrode of a power supply in the power sourcing equipment, and the second cable may be connected to a positive electrode of the power supply in the power sourcing equipment.

Based on a same inventive concept, this application further provides a validity detection method. The method mainly includes the following steps:
i. The first communications device enters the first state.
   The first communications device judges or determines that the first communications device meets a corresponding condition, and enters the first state.
ii. The first communications device controls the first load in the first communications device to be in the connected state. The second load in the first communications device is in the disconnected state in all or the part of the time in which the first load is in the connected state.
iii. The first communications device controls the second load to be in the connected state.

That the first load is in the connected state indicates that the first load is in a path connection state, there is a current flowing through the first load, and the first load is in an operation state. That the second load is in the disconnected state indicates that the second load is in an open circuit state, there is a current flowing through the second load, and the second load is in an operation state. The first state may be a detection state. The detection state may be specifically a DO_DETECTION state, to indicate that the second communications device connected to the first communications device performs validity detection on the first communications device.

Further, in all or the part of the time of the first state, the second load is in the disconnected state. In other words, when the first communications device enters the first state, the second load is in the disconnected state; or after the first communications device enters the first state, the second load is in the disconnected state.

In specific implementation, when the second load is in the connected state, the first communications device controls the first load to be in the disconnected state, so that the first load does not affect the second load when the second load is in an operation state. Especially in a scenario in which the first communications device is connected to the second communications device by using only a pair of cables, when the second load is in the connected state, the first communications device controls the first load to be in the disconnected state, so that the first load is not connected in parallel between the pair of cables when the second communications device completes the validity detection on the first communications device. In this way, the following case can be avoided: The first load affects data transmission between the first communications device and the second communications device when the first communications device operates.

In a possible implementation, the first communications device may enter the first state by using the following steps: receiving instruction information sent by the second communications device, and determining, based on the instruction information, that the current state is the first state, where the instruction information is used to instruct the first communications device to determine that the current state is the first state. Specifically, the instruction information may be a voltage signal or a current signal used to trigger the first communications device to enter the first state, for example, a square wave signal and/or a pulse signal; or may be a message used to instruct the first communications device to determine that the current state is the first state.

Further, the first communications device specifically enters the first state by using the following steps: detecting that a first condition is met, and entering the first state.

Specifically, the first communications device may use the following steps to detect whether the first condition is met: detecting whether a voltage output by the second communications device to the first communications device meets the first condition. The first condition is that the voltage output by the second communications device to the first communications device is greater than or equal to a specified voltage threshold, or the first condition is that the voltage output by the second communications device to the first communications device is within a specified voltage range.

The specified voltage threshold and the specified voltage range may be determined based on the voltage output when the second communications device performs the validity detection on the first communications device.

Correspondingly, the second communications device detects a current of the first load 303 in the first communications device; determines a resistance value of the first load 303 based on the detected current and the voltage output to the first communications device; and determines, based on the resistance value of the first load 303, whether the first communications device is valid. Specifically, when the resistance value that is of the first load and that is determined by the second communications device is within a specified valid resistance value range, the second communications device determines that the first communications device is valid; or when the resistance value that is of the first load 303 and that is determined by the second communications device is within a specified invalid resistance value range, the second communications device determines that the first communications device is valid.

Because the resistance value of the first load is a fixed value, after detecting the current in the first load in the first communications device, the second communications device may directly determine, based on the detected current, whether the first communications device is valid. Specifically, when the current detected by the second communications device is within a specified valid current range, the second communications device determines that the first communications device is valid; or when the current detected by the second communications device is within a specified invalid current range, the second communications device determines that the first communications device is valid.

Alternatively, the first communications device may use the following steps to detect whether the first condition is met: detecting whether a current output by the second communications device to the first communications device meets the first condition. The first condition is that the current output by the second communications device to the first communications device is greater than or equal to a specified current threshold, or the first condition is that the current output by the second communications device to the first communications device is within a specified current range.

The specified current threshold and the specified current range may be determined based on the current output when the second communications device performs the validity detection on the first communications device.

Correspondingly, the second communications device detects a voltage of the first load in the first communications device; determines a resistance value of the first load based on the detected voltage and the current output to the first communications device; and determines, based on the resistance value of the first load, whether the first communications device is valid. Specifically, when the resistance value that is of the first load and that is determined by the second communications device is within a specified valid resistance value range, the second communications device determines that the first communications device is valid; or when the resistance value that is of the first load and that is determined by the second communications device is within a specified invalid resistance value range, the second communications device determines that the first communications device is valid.

Because the resistance value of the first load is a fixed value, after detecting the voltage of the first load in the first communications device, the second communications device may directly determine, based on the detected voltage, whether the first communications device is valid. Specifically, when the voltage detected by the second communications device is within a specified valid voltage range, the second communications device determines that the first communications device is valid; or when the voltage detected by the second communications device is within a specified invalid voltage range, the second communications device determines that the first communications device is valid.

After the second communications device determines that the first communications device is valid, the second communications device may further detect a power level of the first communications device; and supply power to the first communications device based on the power level of the first communications device, or supply power to the first communications device based on a preset power level.

Specifically, the second communications device may further detect the power level of the first communications device by using the following method: sending a power level request message to the first communications device; and receiving a response message that is of the power level request message and that is sent by the first communications device, where the response message carries the power level of the first communications device.

After the second communications device determines that the first communications device is valid, the second communications device may further continue to perform the validity detection after preset duration, for example, continue to output a voltage or a current for the validity detection; or after it is determined that the second communications device is connected to a new first communications device, the second communications device performs validity detection on the new first communications device, for example, outputs a voltage or a current for the validity detection.

In a possible implementation, the first communications device may further determine that the current state is a second state. The second state may be a classification state, for example, a DO_CLASS_EVENT state; or may be a power-on state, for example, a POWERED state.

Further, the first communications device may enter the second state by using the following method: in all or a part of a time in which the first load is in the connected state, detecting whether a second condition is met, and entering the second state.

Specifically, the first communications device may use the following method to detect whether the second condition is met: detecting whether a voltage output by the second communications device to the first communications device meets the second condition. The second condition is that the voltage output by the second communications device to the first communications device is greater than or equal to a specified voltage threshold, and duration of the voltage output by the second communications device to the first communications device is greater than a specified value; or the second condition is that the voltage output by the second communications device to the first communications device is less than the specified voltage threshold; or the second condition is that the voltage output by the second communications device to the first communications device is outside a specified voltage range.

Alternatively, the first communications device may use the following method to detect whether the second condition is met: detecting whether a current output by the second communications device to the first communications device meets the second condition. The second condition is that the current output by the second communications device to the first communications device is greater than or equal to a specified current threshold, and duration of the current output by the second communications device to the first communications device is greater than a specified value; or the second condition is that the current output by the second communications device to the first communications device is less than the specified current threshold; or the second condition is that the current output by the second communications device to the first communications device is outside a specified current range.

In the foregoing method, the first communications device enters the first state, and controls the first load to be in the connected state. The second load is in the disconnected state in all or the part of the time in which the first load is in the connected state. In other words, when the first communications device is in the first state, the first load operates, and the second load does not operate, so that the second communications device connected to the first communications device performs the validity detection on the first communications device by using the first load, which is not affected by the second load. In addition, standard configuration may be performed on an impedance of the first load according to a requirement. In comparison with the prior art, a detection result has relatively high accuracy. In addition, the first communications device may further control the second load to be in the connected state, so that the first communications device can be normally powered on and operate after the validity detection is completed.

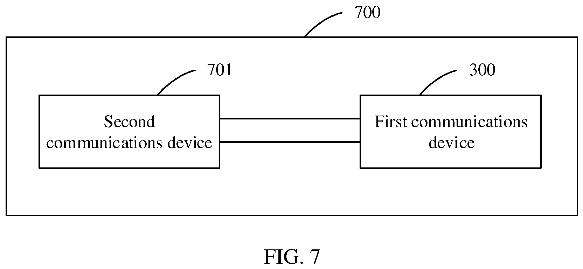

Based on the foregoing implementations, this application further provides a communications system. As shown in FIG. 7, the communications system 700 includes the first communications device 300 in any possible implementation and a second communications device 701. The first communications device 300 is connected to the second communications device by using a cable.

The second communications device 701 is configured to: trigger the first communications device to enter the first state; detect a voltage or a current output by the first communications device 300; and determine, based on the detected voltage or current, whether the first communications device 300 is valid.

The first communications device may be a powered device, and the second communications device may be power sourcing equipment. For a structure and a specific function of the first communications device 300, refer to related descriptions of the first communications device in the foregoing implementations. For a specific function of the second communications device 701, refer to related descriptions of the second communications device in the foregoing implementations. Details are not described herein again.

This application is described with reference to the flowcharts and/or block diagrams of the method, the device (system), and the computer program product according to the implementations of this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer-readable memory that can instruct the computer or any other programmable data processing device to work in a specific manner, so that the instructions stored in the computer readable memory generate an artifact that includes an instruction apparatus. The instruction apparatus implements a specific function in one or more processes in the flowcharts and/or in one or more blocks in the block diagrams.

These computer program instructions may be loaded onto a computer or another programmable data processing device, so that a series of operations and steps are performed on the computer or the another programmable device, thereby generating computer-implemented processing. Therefore, the instructions executed on the computer or the another programmable device provide steps for implementing a specific function in one or more processes in the flowcharts and/or in one or more blocks in the block diagrams.

The scope of protection shall be defined by the appended claims.

## Claims

1. A powered device, PD, adapted to receive power and data from a power source equipment, PSE, in a power over Ethernet, PoE, system, wherein the PD is operable at least in a detection state and a powered state, and the PD comprises a determining unit (301), a control unit (302), a first load (303) and a second load (304); **characterized in that**:
the determining unit is configured to determine an operating state of the PD; and
the control unit is configured to:
when the operating state of the PD is determined to be the detection state, control the first load to be in a connected state and control the second load to be in a disconnected state; and
when the detection state is completed, control the first load to be in a disconnected state and control the second load to be in a connected state.

2. The powered device according to claim 1, wherein the first load is a signature resistor and the second load is a powered load in the PD.

3. The powered device according to claim 1 or 2, wherein the determining unit is specifically configured to:
receive instruction information sent by the PSE, and determine, based on the instruction information, that the current state is the detection state, wherein the instruction information is used to instruct the PD to determine that the operating state to be the detection state.

4. The powered device according to claim 3, further comprising:
a detection unit, configured to detect whether a first condition is met, and wherein the determining unit is configured to determine that the operating state of the PD is the detection state when the first condition is met.

5. The powered device according to claim 4, wherein the detection unit is specifically configured to detect whether a voltage output by the PSE to the PD meets the first condition, wherein
the first condition is that the voltage output by the PSE to the PD is greater than or equal to a specified voltage threshold, or the first condition is that the voltage output by the PSE to the PD is within a specified voltage range.

6. The powered device according to claim 4, wherein the detection unit is specifically configured to detect whether a current output by the PSE to the PD meets the first condition, wherein
the first condition is that the current output by the PSE to the PD is greater than or equal to a specified current threshold, or the first condition is that the current output by the PSE to the PD is within a specified current range.

7. The powered device according to any one of claims 1 to 6, wherein the determining unit is further configured to determine that the operating state of the PD is the powered state.

8. The powered device according to claim 7, wherein the detection unit is further configured to detect whether a second condition is met when the first load is in the connected state, wherein the determining unit is configured to determine that the operating state of the PD is the powered state when the second condition is met.

9. The powered device according to claim 8, wherein the detection unit is specifically configured to detect whether the voltage output by the PSE to the PD meets the second condition, wherein
the second condition is that the voltage output by the PSE to the PD is greater than or equal to a specified voltage threshold, and duration of the voltage output by the PSE to the PD is greater than a specified value; or the second condition is that the voltage output by the PSE to the PD is less than the specified voltage threshold; or the second condition is that the voltage output by the PSE to the PD is outside a specified voltage range.

10. The powered device according to claim 8, wherein the detection unit is specifically configured to detect whether the current output by the PSE to the PD meets the second condition, wherein
the second condition is that the current output by the PSE to the PD is greater than or equal to a specified current threshold, and duration of the current output by the PSE to the PD is greater than a specified value; or the second condition is that the current output by the PSE to the PD is less than the specified current threshold; or the second condition is that the current output by the PSE to the PD is outside a specified current range.

11. A method for operating a powered device according to any one of claims 1 to 10, the method being **characterized by**:
determining an operating state of the PD; and
when the operating state of the PD is determined to be a detection state, controlling the first load to be in a connected state and controlling the second load to be in a disconnected state; and
when the detection state is completed, controlling the first load to be in a disconnected state and controlling the second load to be in a connected state.

## Patentansprüche

1. Strombetriebenes Gerät, PD, das geeignet ist, Strom und Daten von einem "Power Source Equipment", PSE, in einem "Power over Ethernet", PoE, -System zu beziehen, wobei das PD wenigstens in einem Detektionszustand und in einem gespeisten Zustand betreibbar ist und das PD eine Bestimmungseinheit (301), eine Steuereinheit (302), eine erste Last (303) und eine zweite Last (304) umfasst: **dadurch gekennzeichnet, dass**:
die Bestimmungseinheit dazu ausgebildet ist, einen Betriebszustand des PD zu bestimmen, und
die Steuereinheit dazu ausgebildet ist:
wenn bestimmt ist, dass der Betriebszustand des PD der Detektionszustand ist, die erste Last so zu steuern, dass sie sich in einem verbundenen Zustand befindet, und die zweite Last so zu steuern, dass sie sich in einem getrennten Zustand befindet, und
wenn der Detektionszustand abgeschlossen ist, die erste Last so zu steuern, dass sie sich in einem getrennten Zustand befindet, und die zweite Last so zu steuern, dass sie sich in einem verbundenen Zustand befindet.

2. Strombetriebenes Gerät nach Anspruch 1, wobei die erste Last ein Signatur-Widerstand und die zweite Last eine gespeiste Last im PD ist.

3. Strombetriebenes Gerät nach Anspruch 1 oder 2, wobei die Bestimmungseinheit eigens dazu ausgebildet ist:
Anweisungsinformationen zu empfangen, die vom PSE gesendet werden, und basierend auf den Anweisungsinformationen zu bestimmen, dass der aktuelle Zustand der Detektionszustand ist, wobei die Anweisungsinformationen dafür genutzt werden, das PD anzuweisen, zu bestimmen, dass der Betriebszustand der Detektionszustand sein soll.

4. Strombetriebenes Gerät nach Anspruch 3, ferner umfassend:
eine Detektionseinheit, die dazu ausgebildet ist, zu detektieren, ob eine erste Bedingung erfüllt ist, und wobei die Bestimmungseinheit dazu ausgebildet ist, zu bestimmen, dass der Betriebszustand des PD der Detektionszustand ist, wenn die erste Bedingung erfüllt ist.

5. Strombetriebenes Gerät nach Anspruch 4, wobei die Detektionseinheit eigens dazu ausgebildet ist, zu detektieren, ob eine Spannung, die vom PSE an das PD ausgegeben wird, die erste Bedingung erfüllt, wobei die erste Bedingung ist, dass die Spannung, die vom PSE an das PD ausgegeben wird, größer als oder gleich einer vorgegebenen Spannungsschwelle ist, oder die erste Bedingung ist, dass die Spannung, die vom PSE an das PD ausgegeben wird, innerhalb eines vorgegebenen Spannungsbereichs liegt.

6. Strombetriebenes Gerät nach Anspruch 4, wobei die Detektionseinheit eigens dazu ausgebildet ist, zu detektieren, ob ein Strom, der vom PSE an das PD ausgegeben wird, die erste Bedingung erfüllt, wobei
die erste Bedingung ist, dass der Strom, der vom PSE an das PD ausgegeben wird, größer als oder gleich einer vorgegebenen Stromschwelle ist, oder die erste Bedingung ist, dass der Strom, der vom PSE an das PD ausgegeben wird, innerhalb eines vorgegebenen Strombereichs liegt.

7. Strombetriebenes Gerät nach einem der Ansprüche 1 bis 6, wobei die Bestimmungseinheit ferner dazu ausgebildet ist, zu bestimmen, dass der Betriebszustand des PD der gespeiste Zustand ist.

8. Strombetriebenes Gerät nach Anspruch 7, wobei die Detektionseinheit ferner dazu ausgebildet ist, zu detektieren, ob eine zweite Bedingung erfüllt ist, wenn sich die erste Last im verbundenen Zustand befindet, wobei die Bestimmungseinheit dazu ausgebildet ist, zu bestimmen, dass der Betriebszustand des PD der gespeiste Zustand ist, wenn die zweite Bedingung erfüllt ist.

9. Strombetriebenes Gerät nach Anspruch 8, wobei die Detektionseinheit eigens dazu ausgebildet ist, zu detektieren, ob die Spannung, die vom PSE an das PD ausgegeben wird, die zweite Bedingung erfüllt, wobei
die zweite Bedingung ist, dass die Spannung, die vom PSE an das PD ausgegeben wird, größer als oder gleich einer vorgegebenen Spannungsschwelle ist, und eine Dauer der Spannungsausgabe vom PSE an das PD größer als ein vorgegebener Wert ist, oder die zweite Bedingung ist, dass die Spannung, die vom PSE an das PD ausgegeben wird, kleiner als die vorgegebene Spannungsschwelle ist, oder die zweite Bedingung ist, dass die Spannung, die vom PSE an das PD ausgegeben wird, außerhalb eines vorgegebenen Spannungsbereichs liegt.

10. Strombetriebenes Gerät nach Anspruch 8, wobei die Detektionseinheit eigens dazu ausgebildet ist, zu detektieren, ob der Strom, der vom PSE an das PD ausgegeben wird, die zweite Bedingung erfüllt, wobei
die zweite Bedingung ist, dass der Strom, der vom PSE an das PD ausgegeben wird, größer als oder gleich einer vorgegebenen Stromschwelle ist, und eine Dauer der Stromausgabe vom PSE an das PD größer als ein vorgegebener Wert ist, oder die zweite Bedingung ist, dass der Strom, der vom PSE an das PD ausgegeben wird, kleiner als die vorgegebene Stromschwelle ist, oder die zweite Bedingung ist, dass der Strom, der vom PSE an das PD ausgegeben wird, außerhalb eines vorgegebenen Strombereichs liegt.

11. Verfahren zum Betrieb eines strombetriebenen Geräts nach einem der Ansprüche 1 bis 10, wobei das Verfahren durch Folgendes gekennzeichnet ist Bestimmen eines Betriebszustands des PD; und
wenn bestimmt ist, dass der Betriebszustand des PD ein Detektionszustand ist, Steuern der ersten Last so, dass sie sich in einem verbundenen Zustand befindet, und Steuern der zweiten Last so, dass sie sich in einem getrennten Zustand befindet, und
wenn der Detektionszustand abgeschlossen ist, Steuern der ersten Last so, dass sie sich in einem getrennten Zustand befindet, und Steuern der zweiten Last so, dass sie sich in einem verbundenen Zustand befindet.

## Revendications

1. Dispositif alimenté, PD, prévu pour recevoir une alimentation et des données en provenance d'un équipement source d'alimentation. PSE, dans un système d'alimentation par Ethernet, PoE, le PD pouvant fonctionner au moins dans un état de détection et un état alimenté, et le PD comportant une unité (301) de détermination, une unité (302) de commande, une première charge (303) et une seconde charge (304) ; **caractérisé en ce que** :
l'unité de détermination est configurée pour déterminer un état de fonctionnement du PD ; et
l'unité de commande est configurée pour :
lorsqu'il est déterminé que l'état de fonctionnement du PD est l'état de détection, commander la première charge pour qu'elle soit dans un état connecté et commander la seconde charge pour qu'elle soit dans un état déconnecté ; et
lorsque l'état de détection est terminé, commander la première charge pour qu'elle soit dans un état déconnecté et commander la seconde charge pour qu'elle soit dans un état connecté.

2. Dispositif alimenté selon la revendication 1, la première charge étant une résistance de signature et la seconde charge étant une charge alimentée dans le PD.

3. Dispositif alimenté selon la revendication 1 ou 2, l'unité de détermination étant spécifiquement configurée pour :
recevoir des informations d'instruction émises par le PSE, et déterminer, d'après les informations d'instruction, que l'état actuel est l'état de détection, les informations d'instruction étant utilisées pour donner comme instruction au PD de déterminer que l'état de fonctionnement est l'état de détection.

4. Dispositif alimenté selon la revendication 3, comportant en outre :
une unité de détection, configurée pour détecter si une première condition est satisfaite, et l'unité de détermination étant configurée pour déterminer que l'état de fonctionnement du PD est l'état de détection lorsque la première condition est satisfaite.

5. Dispositif alimenté selon la revendication 4, l'unité de détection étant spécifiquement configurée pour détecter si une tension délivrée par le PSE au PD satisfait la première condition,
la première condition étant que la tension délivrée par le PSE au PD soit supérieure ou égale à un seuil de tension spécifié, ou la première condition étant que la tension délivrée par le PSE au PD se situe à l'intérieur d'une plage de tension spécifiée.

6. Dispositif alimenté selon la revendication 4, l'unité de détection étant spécifiquement configuré pour détecter si un courant délivré par le PSE au PD satisfait la première condition,
la première condition étant que le courant délivré par le PSE au PD soit supérieur ou égal à un seuil de courant spécifié, ou la première condition étant que le courant délivré par le PSE au PD se situe à l'intérieur d'une plage de courant spécifiée.

7. Dispositif alimenté selon l'une quelconque des revendications 1 à 6, l'unité de détermination étant en outre configurée pour déterminer que l'état de fonctionnement du PD est l'état alimenté.

8. Dispositif alimenté selon la revendication 7, l'unité de détection étant en outre configurée pour détecter si une seconde condition est satisfaite lorsque la première charge est dans l'état connecté, l'unité de détermination étant configurée pour déterminer que l'état de fonctionnement du PD est l'état alimenté lorsque la seconde condition est satisfaite.

9. Dispositif alimenté selon la revendication 8, l'unité de détection étant spécifiquement configurée pour détecter si la tension délivrée par le PSE au PD satisfait la seconde condition,
la seconde condition étant que la tension délivrée par le PSE au PD soit supérieure ou égale à un seuil de tension spécifié, et qu'une durée de la tension délivrée par le PSE au PD soit supérieure à une valeur spécifiée ; ou la seconde condition étant que la tension délivrée par le PSE au PD soit inférieure au seuil de tension spécifié ; ou la seconde condition étant que la tension délivrée par le PSE au PD se situe en dehors d'une plage de tension spécifiée.

10. Dispositif alimenté selon la revendication 8, l'unité de détection étant spécifiquement configurée pour détecter si le courant délivré par le PSE au PD satisfait la seconde condition,
la seconde condition étant que le courant délivré par le PSE au PD soit supérieur ou égal à un seuil de courant spécifié, et qu'une durée du courant délivré par le PSE au PD soit supérieure à une valeur spécifiée ; ou la seconde condition étant que le courant délivré par le PSE au PD soit inférieur au seuil de courant spécifié ; ou la seconde condition étant que le courant délivré par le PSE au PD se situe en dehors d'une plage de courant spécifiée.

11. Procédé d'exploitation d'un dispositif alimenté selon l'une quelconque des revendications 1 à 10, le procédé étant **caractérisé par** les étapes consistant à :
déterminer un état de fonctionnement du PD ; et
lorsqu'il est déterminé que l'état de fonctionnement du PD est un état de détection, commander la première charge pour qu'elle soit dans un état connecté et commander la seconde charge pour qu'elle soit dans un état déconnecté ; et
lorsque l'état de détection est terminé, commander la première charge pour qu'elle soit dans un état déconnecté et commander la seconde charge pour qu'elle soit dans un état connecté.
